# EUROPÄISCHE PATENTANMELDUNG

(11) **EP 0 534 131 A2**
(43) Veröffentlichungstag der Anmeldung: **31.03.1993**
(21) Anmeldenummer: 92114163.6
(22) Anmeldetag: 19.08.1992
(51) Int. Cl.: H01L 29/784

(54) **MOS-Technik in SOI-Technik**

(30) Priorität: 27.09.1991 DE 4132303
(71) Anmelder: SIEMENS AKTIENGESELLSCHAFT, D-80333 München (DE)
(72) Erfinder: Wieder, Armin, Dr., W-8130 Starnberg-Percha (DE); Kircher, Roland, Dr., W-8521 Aurachtal-Münchaurach (DE)

(57) **Zusammenfassung**

Auf einer isolierenden Schicht (12), die auf einem Substrat (11) aus einkristallinem Silizium angeordnet ist, ist zwischen Source- und Drain-Gebiet (14) ein Kanalgebiet (13) aus dotiertem, einkristallinem Silizium angeordnet. An der Oberfläche des Kanalgebietes (13) ist ein Gatedielektrikum (15) und darauf eine Gateelektrode (16) angeordnet. Die Länge des Kanalgebietes (13) zwischen Source- und Drain-Gebiet (14) ist größenordnungsmäßig im wesentlichen gleich der Dicke des Kanalgebietes (13) zwischen der isolierenden Schicht (12) und dem Gatedielektrikum (15). Insbesondere weist das Kanalgebiet (13) eine Länge von 15 nm bis 100 nm auf.

## Beschreibung

Die Entwicklung in der Mikroelektronik geht in Richtung einer Verkleinerung der Bauelemente. Durch den geringeren Platzbedarf des einzelnen Bauelementes wird eine höhere Packungsdichte angestrebt.

Bei der Verkleinerung von MOS-Transistoren sollen dabei die guten Schalteigenschaften mindestens erhalten bleiben.

In der Mikroelektronik werden als MOS-Transistor im allgemeinen Transistoren verwendet, bei denen Source-, Drain- und Kanalgebiet in einem Substrat aus einkristallinem Silizium angeordnet sind. Diese MOS-Transistoren werden auch Bulk-Transistoren genannt. Verringert man bei diesen Bulk-Transistoren die Länge des Kanalgebietes zwischen Source- und Drain-Gebiet, so verschlechtert sich das Schaltverhalten durch Kurzkanaleffekte zunehmend. Es ist abzusehen, daß bei diesen Bulk-Transistoren eine Grenze in der Verringerung der Kanallänge erreicht wird, unterhalb der die Schalteigenschaften so schlecht werden, daß der Transistor nicht mehr brauchbar ist. Als minimal erreichbare Kanallänge solcher Bulk-Transistoren wird eine Kanallänge von etwa 0,1 µm angesehen.

Eine Alternative ist in MOS-Transistoren in SOI-Technik, den sogenannten SOI-Transistoren, zu sehen. Als SOI-Transistor bezeichnet man einen MOS-Transistor, dessen Source-, Kanal- und Drain-Gebiet in einer einkristallinen Siliziumschicht angeordnet sind. Diese einkristalline Siliziumschicht ist durch eine isolierende Schicht aus z. B. Siliziumdioxid von einem Substrat, das weitere Schaltelemente enthält, isoliert. Dadurch kann ein Teil der Kurzkanaleffekte unterdrückt werden. Bei kleiner werdender Kanallänge verschlechtert sich jedoch das Subthreshold-Verhalten dieser MOS-Transistoren in SOI-Technik und damit das Schaltverhalten des MOS-Transistors.

Der Erfindung liegt daher das Problem zugrunde, einen MOS-Transistor anzugeben, dessen Kanallänge über die bisher erwarteten Grenzen hinaus verkleinert werden kann, ohne daß sich dabei das Schaltverhalten verschlechtert.

Das Problem wird erfindungsgemäße gelöst durch einen MOS-Transistor nach Anspruch 1. Größenordnungsmäßig gleich bedeutet dabei, daß das Verhältnis Länge des Kanalgebiets zu Dicke des Kanalgebiets zwischen 1 und 4 liegen muß. Als beste Ausführungsform wird dabei der Wert 1,0 angestrebt, insbesondere für eine Kanallänge kleiner oder gleich 20 nm.

Die Erfindung macht sich die Erkenntnis zunutze, daß die Schaltgeschwindigkeit eines MOS-Transistors in SOI-Technik als Funktion des Quotienten Länge des Kanalgebietes zwischen Source und Drain und Dicke des Kanalgebietes zwischen der isolierenden Schicht und dem Gatedielektrikum maximal ist, wenn dieser Quotient in der Größenordnung 1 ist. Der erfindungsgemäße MOS-Transistor weist daher sehr schnelle Schalteigenschaften auf. Da bei Abmessungen in dieser Größenordnung die gesamte Schichtdicke zwischen der isolierenden Schicht und dem Gatedielektrikum als Kanalgebiet zum Ladungstransport beiträgt, ist die Strombelastbarkeit des Transistors hoch.

Der erfindungsgemäße MOS-Transistor zeigt ein sehr gutes Subthreshold-Verhalten, so daß die Länge des Kanalgebietes extrem verringert werden kann. Die Länge des Kanalgebietes wird lediglich dadurch begrenzt, daß die Schicht, aus der das Kanalgebiet besteht, in dieser Dicke gut kontrollierbar hergestellt werden muß, damit die Bedingung Länge zu Dicke des Kanalgebietes größenordnungsmäßig gleich 1 eingehalten werden kann. Prinzipiell ist der Verkürzung der Kanallänge aufgrund der physikalischen Verhältnisse eine Grenze gesetzt, unterhalb der sich kein Kanal zwischen Source- und Drain-Gebiet mehr ausbildet. Es liegt daher im Rahmen der Erfindung, den MOS-Transistor so auszubilden, daß das Kanalgebiet eine Länge zwischen 15 und 100 nm, vorzugsweise 20 nm aufweist. Diese Ausführungsform der Erfindung weist einen sehr geringen Platzbedarf auf.

Eine weitere Verbesserung des Subthreshold-Verhaltens wird dadurch erzielt, daß die Gateelektrode so oberhalb des Kanalgebietes angeordnet ist, daß die Grenzfläche zwischen Kanalgebiet und Source-Gebiet sowie zwischen Kanalgebiet und Drain-Gebiet in der Nähe gegenüberliegender Kanten der Gateelektrode liegen. Das heißt, daß eine Überlappung der Gateelektrode mit Source- und Drain-Gebiet vermieden wird. Eine solche Überlappung führt infolge parasitärer Kapazitäten zu einer Verschlechterung des Schaltverhaltens. Diese wird durch die Ausführungsform der Erfindung vermieden.

Source-, Drain- und Kanal-Gebiet werden erfindungsgemäß zum Substrat hin durch die isolierende Schicht begrenzt. Wenn die Dicke von Source- und Drain-Gebiet senkrecht zur Oberfläche der isolierenden Schicht im wesentlichen gleich der Dicke des Kanalgebietes in dieser Richtung ist, weist der MOS-Transistor eine planare Struktur auf. Dieses erweist sich für die Integration in einer integrierten Schaltung als günstig.

Das Gatedielektrikum besteht insbesondere aus einem thermischen Oxid oder aus Ta₂O₅. Bei Verwendung von Ta₂O₅ wird das vertikale elektrische Feld um einen Faktor 5 bis 6 reduziert. Die Verwendung von thermischen Oxid hat den Vorteil, daß dieses in einem Standard-Prozeß gut kontrollierbar hergestellt werden kann.

Source- und Drain-Gebiet müssen aus einem leitfähigen Material bestehen, das guten Kontakt zum Kanalgebiet hat. Source- und Drain-Gebiet werden z. B. aus Wolfram, Silizid oder dotiertem Silizium gebildet. Im letzten Fall ist der Leitfähigkeitstyp entgegengesetzt zu demjenigen des Kanalgebiets.

Der MOS-Transistor mit Source- und Drain-Gebiet aus dotiertem einkristallinem Silizium hat den Vorteil, daß Source- und Drain-Gebiet aus derselben Schicht herstellbar sind, aus der auch das Kanalgebiet hergestellt wird. Die entsprechenden Teile der Schicht müssen lediglich anders dotiert werden.

Der MOS-Transistor mit Source und Drain aus dotiertem polykristallinem Silizium hat den Vorteil, daß für die Dotierung von Source- und Drain-Gebiet sowie des Kanalgebietes keine Maske erforderlich ist.

Weitere Ausgestaltungen der Erfindung gehen aus den übrigen Ansprüchen hervor.

Im folgenden wird die Erfindung anhand der Figuren und eines Ausführungsbeispiels näher erläutert.
- In Fig. 1: ist der prinzipielle Aufbau des erfindungsgemäßen MOS-Transistors dargestellt.
- In Fig. 2: bis Fig. 6 sind Verfahrensschritte zur Herstellung eines erfindungsgemäßen MOS-Transistors dargestellt.

Auf einem Substrat 11 aus p-dotiertem Silizium ist eine isolierende Schicht 12 angeordnet. Die isolierende Schicht 12 besteht z. B. aus SiO₂ und weist eine Dicke von etwa 50 nm auf. Auf der isolierenden Schicht 12 ist ein Kanalgebiet 13 aus einkristallinem, p-dotiertem Silizium angeordnet. Das Kanalgebiet 13 ist z. B. mit Bor dotiert, wobei die Dotierung mindestens 4 x 10¹⁶ cm⁻³ beträgt.

Seitlich des Kanalgebietes 13 ist an gegenüberliegenden Seiten des Kanalgebietes 13 ein Source- und ein Drain-Gebiet 14 angeordnet. Source- und Drain-Gebiet 14 bestehen z. B. aus n-dotiertem, einkristallinem Silizium und stehen in elektrischem Kontakt zum Kanalgebiet 13. Source- und Drain-Gebiet 14 sind z. B. mit Arsen dotiert, wobei die Dotierung zwischen 5 x 10¹⁹ und 5 x 10²⁰ cm⁻³ liegt.

Das Kanalgebiet 13 weist zwischen Source- und Drain-Gebiet eine Länge von z. B. 20 nm auf. In Richtung senkrecht zur Oberfläche zu isolierenden Schicht 12 weist das Kanalgebiet 13 eine Länge von ebenfalls 20 nm auf.

An der Oberfläche des Kanalgebiets 13 ist ein Gatedielektrikum 15 angeordnet. Das Gatedielektrikum besteht z. B. aus thermischem Siliziumdioxid oder Ta₂O₅ und weist eine Dicke von z. B. 10 nm auf. Oberhalb des Gatedielektrikums ist eine Gateelektrode 16 angeordnet, die z. B. aus polykristallinem Silizium besteht. Je nach dem auf welchen Wert die Einsatzspannung des MOS-Transistors eingestellt werden soll, wird das Polysilizum n+- oder p+-dotiert.

Die Gateelektrode 16 und das Gatedielektrikum 15 sind von einer Isolationsstruktur 17, die z. B. aus Siliziumdioxid besteht, vollständig eingekapselt. Die Isolationsstrutur 17 wird vielfach auch als capping oxide bezeichnet. Die Isolationsstruktur 17 dient zur lateralen Isolation der Gateelektrode 16.

Oberhalb von Source- und Drain-Gebiet 14 sind jeweils Kontakte 18 zur Kontaktierung der Source- und Drain-Gebiete 14 angeordnet. Die Kontakte 18 bestehen aus einem leitfähigen Material, z. B. Wolfram.

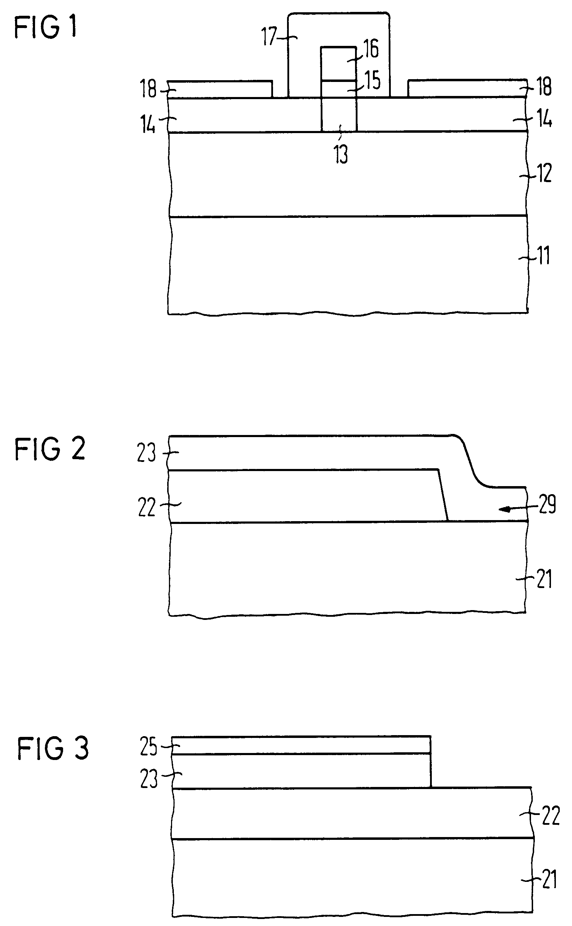

Die anhand von Fig. 1 erläuterte Ausführungsform des MOS-Transistors weist ein Kanalgebiet 13 auf, bei dem das Verhältnis von Dicke des Kanalgebiets senkrecht zur Oberfläche der isolierenden Schicht 12 zu Länge des Kanalgebiets 13 zwischen Source- und Drain-Gebiet 14 den Wert 1 annimmt. Des weiteren zeigen Source- und Drain-Gebiet 14 keine Unterdiffusion unter die Gateelektrode 16 und das Gatedielektrikum 15. Damit erfüllt diese Ausführungsform die Bedingung für höchstmögliche Schaltgeschwindigkeit. Dieses wurde mit Hilfe von Simulationsrechnungen belegt. Diese Simulationsrechnungen haben gezeigt, daß die Dicke des Gatedielektrikums auch auf unter 10 nm reduziert werden kann, ohne daß ein negativer Einfluß zu befürchten ist.

Im folgenden wird anhand der Figuren 2 bis 6 ein Herstellverfahren für den erfindungsgemäßen Transistor erläutert.

Auf einem Substrat 21 aus p⁺-dotiertem, einkristallinem Silizium, dessen Oberfläche (100)-orientiert ist, wird durch thermische Oxidation eine isolierende Schicht 22 erzeugt. Die isolierende Schicht 22 wird in einer Dicke von z. B. 50 nm gebildet.

Nach entsprechender Maskierung wird die isolierende Schicht 22 in einem naßchemischen Ätzprozeß strukturiert, so daß innerhalb einer Öffnung 29 die Oberfläche des Substrats 21 freigelegt wird (s. Fig. 2). Die Öffnung 29 wird auch als seeding hole bezeichnet.

Anschließend wird ganzflächig durch chemische Abscheidung aus der Dampfphase bei niedrigem Druck (LPCVD) eine Schicht 23 aus polykristallinem Silizium abgeschieden. Die Schicht 23 aus polykristallinem Silizium wird in einer Dicke von z. B. 25 nm abgeschieden. Sie wird in situ mit Bor dotiert. Dabei beträgt die Borkonzentration in der abgeschiedenen Schicht 23 4 x 10¹⁸ bis 5 x 10¹⁸ cm⁻³. Anschließend wird mit Hilfe einer Wärmequelle die Schicht 23 im Bereich der Öffnung 29 bis auf das Substrat 21 erhitzt. Das polykristalline Silizium darf dabei nicht geschmolzen werden. Durch eine laterale Verschiebung der Wärmequelle über die Schicht 23 im Bereich der isolierenden Schicht 22 wird eine Rekristallisation der Schicht 23 bewirkt. Auf diese Weise wird die Schicht 23 durch laterale solid-Phase-Epitaxie (LSPE) in den einkristallinen Zustand überführt.

Anschließend wird das Silizium im Bereich der Öffnung 29 (seeding hole) rückgeätzt. Anschließend wird eine Schicht 25 für ein Gatedielektrikum erzeugt (s. Fig. 3). Dies erfolgt z. B. durch thermische Oxidation der rekristallisierten Schicht 23 in einer Dicke von z. B. 10 nm. Alternativ kann die Schicht 25 aus Ta₂O₅ in einem CVD-Verfahren abgeschieden werden. In diesem Fall wird die Schicht 23 aus Polysilizium nur in einer Dicke von 20 nm abgeschieden.

Zur Homogenisierung der Bordotierung wird anschließend eine Temperung durchgeführt.

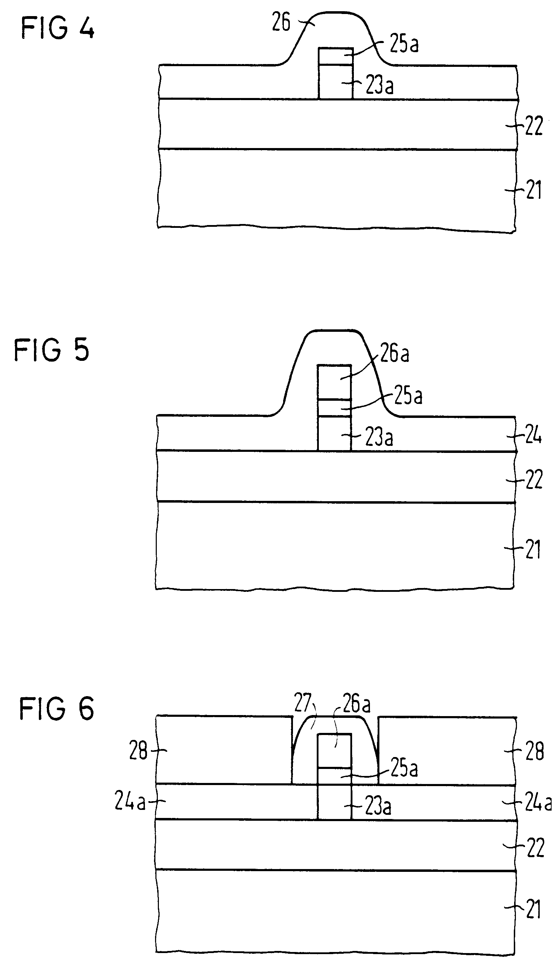

Nach entsprechender Maskierung werden die Schicht 25 für das Gatedielektrikum und die rekristallisierte Schicht 23 in einem anisotropen Ätzprozeß so strukturiert, daß ein Kanalgebiet 23a an der Oberfläche der isolierenden Schicht 22 und darauf ein Gatedielektrikum 25a entstehen. Anschließend wird ganzflächig eine polykristalline Siliziumschicht 26 abgeschieden (s. Fig. 4). Aus der polykristallinen Siliziumschicht 26 wird durch Strukturierung eine Gateelektrode 26a gebildet (s. Fig. 5). Daher ist die polykristalline Siliziumschicht 26, abhängig davon, welcher Wert der Einsatzspannung eingestellt werden soll, n⁺- oder p⁺-dotiert.

Die Gateelektrode 26a wird so strukturiert, daß sie mit dem Gatedielektrikum 25a und dem Kanalgebiet 23a gemeinsame senkrechte Flanken aufweist. Im nächsten Schritt wird ganzflächig eine weitere polykristalline Siliziumschicht 24 abgeschieden. Die weitere polykristalline Siliziumschicht 24 wird n⁺-dotiert in einer Dicke von z. B 20 nm in einem LPCVD-Verfahren abgeschieden. Sie ist z. B. mit Arsen dotiert.

Die weitere polykristalline Siliziumschicht 24 wird so strukturiert, daß dabei seitlich des Kanalgebietes 23a Source- und Drain-Gebiet 24a entstehen. In der Höhe schließen Source- und Drain-Gebiet 24a mit dem Kanalgebiet ab. Seitlich sind sie mit dem Kanalgebiet 23a in elektrischem Kontakt. Dabei sind Source- und Drain-Gebiet 24a an gegenüberliegenden Seiten des Kanalgebietes 23a angeordnet (s. Fig. 6). Anschließend wird eine Isolationsstruktur 27 abgeschieden, die die Gateelektrode 26a und das Gatedielektrikum 25a vollständig bedeckt. Die Isolationsstruktur 27, die auch als capping oxide bezeichnet wird, dient zur lateralen Isolation der Gateelektrode und besteht z. B. aus Siliziumoxid.

An der freiliegenden Oberfläche von Source- und Drain-Gebiet 24a werden Kontakte 28 durch selektive Abscheidung von n⁺-dotiertem Polysilizium oder durch selektive Abscheidung von Wolfram erzeugt (s. Fig. 6).

## Patentansprüche

1. MOS-Transistor in SOI-Technik,
- bei dem auf einer isolierenden Schicht (12, 22) ein Kanalgebiet (13, 23a) aus dotiertem, einkristallinem Silizium angeordnet ist,
- bei dem seitlich des Kanalgebiets (13, 23a) auf gegenüberliegenden Seiten ein Source- und ein Drain-Gebiet (14, 24a) angeordnet sind, die mit dem Kanalgebiet (13, 23a) in elektrischem Kontakt stehen,
- bei dem oberhalb des Kanalgebiets (13, 23a) ein Gatedielektrikum (15, 25a) angeordnet ist,
- bei dem oberhalb des Gatedielektrikums (15, 25a) eine Gateelektrode (16, 26a) angeordnet ist,
- bei dem die Länge des Kanalgebiets (13, 23a) zwischen Source- und Drain-Gebiet (14, 24a) größenordnungsmäßig im wesentlichen gleich der Dicke des Kanalgebiets (13, 23a) zwischen der isolierenden Schicht (12, 22) und dem Gatedielektrikum (15, 25a) ist.

2. MOS-Transistor nach Anspruch 1,
bei dem das Kanalgebiet (13, 23a) eine Länge zwischen 15 und 100 nm aufweist.

3. MOS-Transistor nach Anspruch 1 oder 2,
bei dem das Verhältnis Länge des Kanalgebietes (13, 23a) zu Dicke des Kanalgebietes (13, 23a) zwischen 1 und 4 liegt.

4. MOS-Transistor nach einem der Ansprüche 1 bis 3,
bei dem die Gateelektrode (16, 26a) so oberhalb des Kanalgebietes (13, 23a) angeordnet ist, daß die Grenzfläche zwischen Kanalgebiet (13, 23a) und Source-Gebiet (14, 24a) und die Grenzfläche zwischen Kanalgebiet (13, 23a) und Drain-Gebiet (14, 24a) in der Nähe gegenüberliegender Kanten der Gateelektrode (16, 26a) liegen.

5. MOS-Transistor nach einem der Ansprüche 1 bis 4,
bei dem die Dicke von Source- und Drain-Gebiet (14, 24a) senkrecht zur Oberfläche der isolierenden Schicht (12, 22) im wesentlichen gleich der Dicke des Kanalgebietes (13, 23a) in dieser Richtung ist.

6. MOS-Transistor nach einem der Ansprüche 1 bis 5,
bei dem das Gatedielektrikum (15, 25a) aus einem thermischen Oxid besteht.

7. MOS-Transistor nach einem der Ansprüche 1 bis 5,
bei dem das Gatedielektrikum (15, 25a) aus Ta₂O₅ besteht.

8. MOS-Transistor nach einem der Ansprüche 1 bis 7,
bei dem Source- und Drain-Gebiet (14) aus dotiertem, einkristallinem Silizium bestehen, das vom entgegengesetzten Leitfähigkeitstyp wie das Kanalgebiet (13, 23a) dotiert ist.

9. MOS-Transistor nach einem der Ansprüche 1 bis 7,
bei dem Source- und Drain-Gebiet (24a) aus dotiertem polykristallinem Silizium bestehen, das vom entgegengesetzten Leitfähigkeitstyp wie das Kanalgebiet (23a) dotiert ist.

10. MOS-Transistor nach Anspruch 8 oder 9,
bei dem Source- und Drain-Gebiet (14, 24a) n-dotiert und das Kanalgebiet (13, 23a) p-dotiert ist.

11. MOS-Transistor nach einem der Ansprüche 1 bis 10,
bei dem die isolierende Schicht (12, 22) auf einem Substrat (11, 21) aus einkristallinem Silizium aufgebracht ist.
